**Europäisches Patentamt**

**European Patent Office**

**Office européen des brevets**

(19)

(11) Veröffentlichungsnummer: **0 075 699**
**B1**

(12) **EUROPÄISCHE PATENTSCHRIFT**

(45) Veröffentlichungstag der Patentschrift:
11.06.86

(51) Int. Cl.⁴: **H 04 B 9/00**, G 01 R 15/07

(21) Anmeldenummer: **82107326.9**

(22) Anmeldetag: **12.08.82**

(54) Anordnung zur Übertragung von Messwerten zu einer entfernten Stelle.

(30) Priorität: **24.09.81 DE 3138073**

(43) Veröffentlichungstag der Anmeldung:
**06.04.83 Patentblatt 83/14**

(45) Bekanntmachung des Hinweises auf die Patenterteilung:
**11.06.86 Patentblatt 86/24**

(84) Benannte Vertragsstaaten:
**FR GB**

(56) Entgegenhaltungen:
**EP - A - 0 033 237**
**EP - A - 0 033 237**
**DE - A - 2 829 949**
**DE - A - 2 924 581**

**PATENTS ABSTRACTS OF JAPAN, Band 5, Nr. 91, 13. Juni 1981, Seite (E-61)(763)**
**PATENTS ABSTRACTS OF JAPAN**
**ELECTRONIC DESIGN, Band 26, Nr. 9, 26. April 1978, Seiten 78-80, Rochelle Park, USA, I. MATH:**
*"Optical-fiber links help you sidestep communiations problems. Neither cable capacitance, nor water, nor power lines will stop your signal"*

(73) Patentinhaber: **Siemens Aktiengesellschaft, Berlin und München Wittelsbacherplatz 2, D-8000 München 2 (DE)**

(72) Erfinder: **Baues, Peter, Dr. Ing., Haydnstrasse 10, D-8033 Krailling (DE)**

LIBER, STOCKHOLM 1986

## Beschreibung

Die vorliegende Erfindung betrifft eine Anordnung zur Übertragung von Meßwerten einer Meßgröße von einer Meßstelle zu einer entfernten Stelle nach dem Oberbegriff des Patentanspruchs 1.

Eine Anordnung der genannten Art ist aus der GB-A-20 64 112 bekannt. Diese bekannte Anordnung ist ein Feueralarmsystem, also eine Anordnung zum Melden eines Brandes und damit relativ seltenen Ereignisses. Zwischen diesen seltenen Ereignissen verbleibt genügend Zeit, den Energiespeicher wieder aufzuladen, so daß bei der bekannten Anordnung kein Energiezufuhrproblem besteht.

Aus "Patents Abstracts of Japan", Bd. 5, Nr. 91, 13. Juni 1981 (E-61), (763) ist es in Kombination mit einer optischen Rufsignalübertragung bekannt, eine benötigte Energie in Form einer elektrischen Leistung als Lichtleistung über eine Faser zu übertragen.

Aus der EP-AI-00 33 237 geht ein Informationssammelsystem hervor, bei dem von einer entfernten Stelle über eine optische Leitung eine optische Signalleistung einer Sensoreinrichtung zugeführt wird. In dieser Sensoreinrichtung wird die optische Signalleistung moduliert und über eine optische Leitung einem entfernt angeordneten Detektor zugeführt.

Aufgabe der vorliegenden Erfindung ist es, eine in der industriellen Meßtechnik einsetzbare Anordnung zur Übertragung von Meßwerten einer Meßgröße von einer Meßstelle zu einer entfernten Stelle zu schaffen, die es ermöglicht, in Kombination mit einer optischen Meßwertübertragung die benötigte elektrische Leistung als Lichtleistung zu übertragen und die dadurch die Vorteile der optischen Signalübertragung beibehält.

Diese Aufgabe wird mit einer Anordnung der eingangs genannte Art gelöst, welche die im kennzeichnenden Teil dieses Anspruchs angegebene Merkmalskombination aufweist.

Diese Merkmalskombination gewährleistet, daß die Anordnung in der industriellen Meßtechnik, u.a. in der Fertigungs- und Prozeßkontrolle in der Industrie, in der Militärtechnik, beispielsweise im Hinblick auf Fahrzeuge und Flugkörper, und in der Verkehrstechnik, beispielsweise bei der Steuerung von Motoren, vorteilhaft eingesetzt werden kann. Bei diesen Anwendungen muß die Anordnung für eine Vielzahl von Sensoren geeignet sein, die ihre Meßgröße in der Regel ständig abtasten und analoge elektrische Ausgangssignale abgeben. Mit der erfindungsgemäßen Lösung kann der bei derartiger kontinuierlicher Messung laufend auftretende Energieverlust durch optische Leistungsübertragung laufend ausgeglichen werden.

Die erfindungsgemäße Anordnung ist insbesondere in explosionsgefährdeten Gebieten verwendbar und behält alle Vorteile der optischen Signalübertragung bei, zu denen geringes Gewicht, kleine Abmessungen und hohe Flexibilität der Lichtwellenleiter sowie ihre Beständigkeit gegen die meisten aggressiven chemischen Substanzen gehören, Eigenschaften, die im praktischen Bereich von erheblicher Bedeutung sind. Wegen der geringen Dämpfung der Lichtwellenleiter, die etwa 1 dB/km bis 5 dB/km beträgt, können sehr große Entfernungen überbrückt werden.

Vorteilhafte Ausgestaltungen und Weiterbildungen der erfindungsgemäßen Anordnung gehen aus den Ansprüchen 2 bis 20 hervor.

Die Erfindung wird anhand der Figuren in der folgenden Beschreibung, aus der auch die wesentlichen Vorteile der Erfindung und der aus den Ansprüchen hervorgehenden Ausführungsformen und Weiterbil dungen hervorgehen, näher erläutert. Von den Figuren zeigen:

Figur 1 in einem Blockschaltbild den Aufbau einer erfindungsgemäßen Anordnung, die mit Licht nur einer Wellenlänge arbeitet,

Figur 2 in einem Blockschaltbild den Aufbau einer erfindungsgemäßen Anordnung, die mit zwei verschiedenen Wellenlängen arbeitet, und

Figur 3 ein Ausfürungsbeispiel einer Anordnung gemäß Figur 1, bei dem die Sensoreinrichtung ein Thermoelement aufweist.

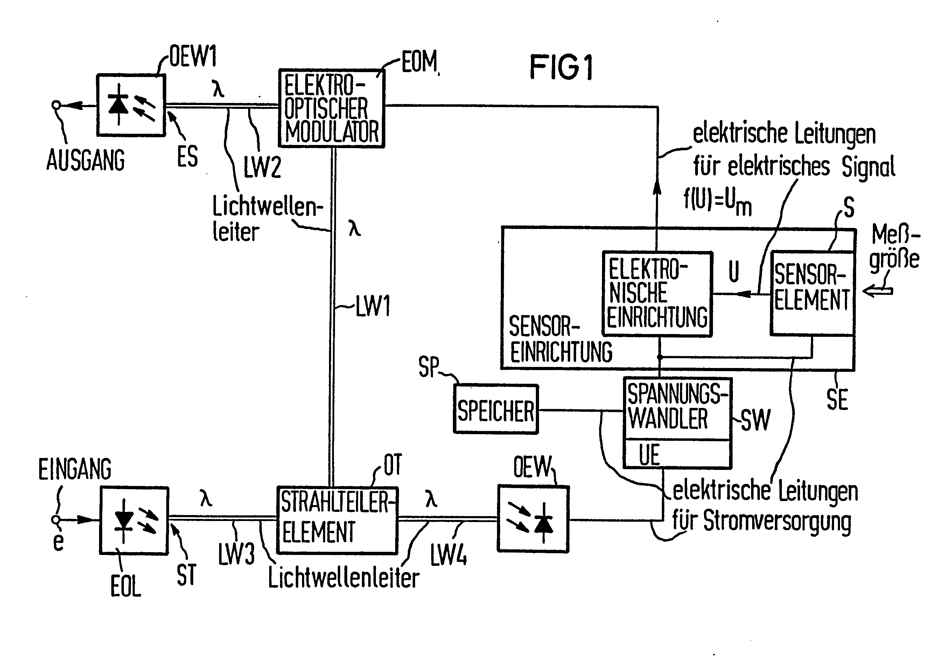

In der in Figur 1 dargestellten Anordnung gibt die an der Meßstelle angeordnete und die Meßgröße abtastende Sensoreinrichtung SE eine von den abgetasteten Meßwerten der Meßgröße abhängige elektrische Spannung $U_m$ als meßwertabhängiges Ausgangssignal ab. Diese meßwertabhängige Spannung $U_m$ wird einem ebenfalls an der Meßstelle und damit nahe bei der Sensoreinrichtung SE angeordneten elektrooptischen Modulator EOM als Steuersignal zugeführt, in welchem einer Signallichtleistung die elektrische Spannung $U_m$ aufgeprägt wird. Die auf diese Weise modulierte Signallichtleistung wird über eine optische Leitung LW2 in Form eines Lichtwellenleiters der entfernten Stelle ES zugefürt, bei der sie zur Weiterverwendung oder -verarbeitung entnommen werden kann.

Von einer von der Sensoreinrichtung SE bzw. der Meßstelle weit entfernten Stelle, ST ist über mindestens einen Lichtwellenleiter LW3 einer zweiten optischen Leitung LW3, LW4 eine Lichtleistung einer bestimmten Wellenläge $\lambda$ einer optischen Teilereinrichtung OT zuführbar, die aus einem Strahlteilerelement besteht. Dieses Strahlteilerelement teilt die über den Lichtwellenleiter LW3 zugefürte Lichtleistung der bestimmten Wellenlänge $\lambda$ in zwei getrennte Leistungsanteile der Wellenlänge $\lambda$ auf, von denen einer in eine weitere optische Leitung LW1 in Form eines Lichtwellenleiters eingekoppelt und als Signallichtleistung dem elektrooptischen Modulator EOM zugeführt wird.

Der andere Leistungsanteil der Wellenlänge $\lambda$ wird als eine für eine Leistungsversorgung der Sensoreinrichtung SE vorgesehene Lichtleistung über einen oder mehrere Lichtwellenleiter LW4 der zweiten optischen Leitung LW3, LW4 einem oder mehreren nahe bei der Sensoreinrichtung SE angeordneten optoelektronischen Wandlern OEW in Form von Fotoelementen zugeführt. Diese Fotoelemente OEW wandeln die zugefürte Lichtleistung in eine elektrische Leistung um, die für den Betrieb des elektrischen Teils der leistungsverbrauchenden Sensoreinrichtung SE erforderlich ist. Es sei darauf hingewiesen, daß eine Anordnung zur Leistungsübertragung über Glasfasern, für sich beispielsweise aus Robertson, M.M: Power transfer via fiber optics, Proceedings of the 30th Electronic Components Conference, San Francisco, CA, USA, 28. - 30. April, 1980, S. 216 - 221, bekannt ist.

Das Teilungsverhältnis des Strahlteilerelements wird vorzugsweise so gewählt, daß nur ein geringer Leistungsanteil, beispielsweise ein Zehntel der zugeführten Lichtleistung, in die weitere optische Leitung LW1 eingekoppelt wird, während der größte Leistungsateil, beispielsweise neun Zehntel der zugeführten Lichtleistung in den oder die weiteren Lichtwellenleiter LW4 der zweiten optischen Leitung LW3, LW4 eingekoppelt werden.

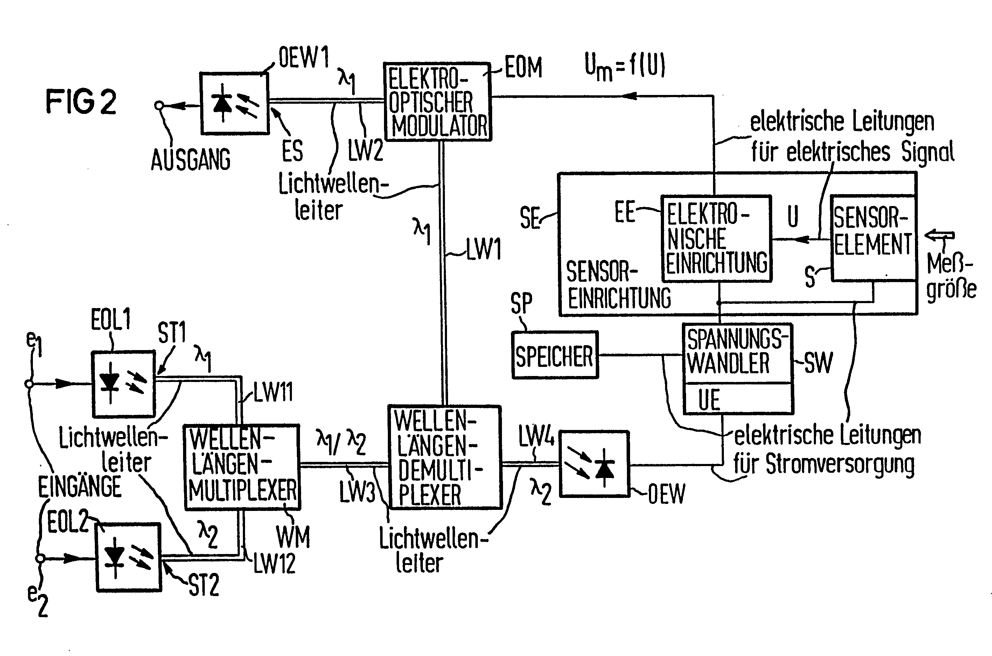

Bevor auf die in der Nähe der Sensoreinrichtung SE befindlichen Komponenten eingegangen wird, die für alle drei in den Figuren 1 bis 3 dargestellten Anordnungen gleich und damit auch mit den gleichen Bezugszeichen versehen sind, wird vorerst auf die in der Figur 2 dargestellte alternative Ausführungsform Bezug genommen.

In dieser Ausführungsform besteht die optische Teilereinrichtung OT aus einem Wellenlängendemultiplexer, der die über den Lichtwellenleiter LW3 der zweiten optischen Leitung LW3, LW4 zugeführte, zwei Lichtwellenlägen $\lambda_1$ und $\lambda_2$ enthaltende Lichtleistung, den beiden Wellenlängen nach in einen Leistungsanteil der einen Wellenlänge $\lambda_1$ und einen davon getrennten Leistungsanteil der anderen Wellenläge $\lambda_2$ aufteilt. Der Leistungsanteil mit der einen Wellenlänge $\lambda_1$, der beispielsweise wieder nur ein Zehntel der zugeführten Gesamtleistung darstellt, wird in die weitere optische Leitung LW1 eingekoppelt und als Signallichtleistung dem elektrooptischen Modulator EOM zugeführt, während der andere, größere Leistungsanteil mit der anderen Wellenlänge $\lambda_2$, der beispielsweise neun Zehntel der zugeführten Gesamtleistung beträgt, über den oder die Lichtwellenleiter LW4 der zweiten optischen Leitung dem oder den Fotoelementen OEW zugeführt wird.

Zur Erzeugung der beiden Leistungsanteile mit den Wellenlängen $\lambda_1$ und $\lambda_2$ wird zweckmäßigerweise so vorgegangen, daß ein Wellenlängenmultiplexer WM vorgesehen ist dem von einer von der Sensoreinrichtung SE entfernten zweiten Stelle ST1 aus eine Lichtleistung der Wellenlänge $\lambda_1$ zugeführt wird,

während ihm von einer von der Sensoreinrichtung SE ebenfalls weit entfernten dritten stelle ST2 eine Lichtleistung der anderen Wellenlänge $\lambda_2$ zugeführt wird. Von dem Wellenlängenmultiplexer WM aus werden diese beiden optischen Lichtleistungen gemeinsam in den Lichtwellenleiter LW3 der zweiten optischen Leitung LW3, LW4 eingekoppelt und dem Wellenlängendemultiplexer zugeführt.

Die Zuführung der beiden Lichtleistungen mit den Wellenlängen $\lambda_1$ und $\lambda_2$ erfolgt zweckmäßigerweise ebenfalls über optische Leitungen, beispielsweise Lichtwellenleiter, die in der Figur 2 mit LW11 und LW12 bezeichnet sind.

Es wird nun auf die nahe bei der Sensoreinrichtung SE angeordneten Komponenten näher eingegangen.

Wie schon erwähnt, wird die in den oder die weiteren Lichtwellenleiter LW4 der zweiten optischen Leitung LW3, LW4 eingekoppelte und für die Leistungsversorgung vorgesehene Lichtleistung einem nahe bei der Sensoreinrichtung SE angeordneten Fotoelement OEW zugeführt. Dieses Fotoelement OEW hat die Aufgabe, die zugeführte Lichtleistung in eine entsprechende elektrische Leistung umzuwandeln, die für den Betrieb eines elektrischen Teiles der leistungsverbrauchenden Sensoreinrichtung SE erforderlich ist.

Allerdings ist die von einem Fotoelement abgegebene Spannung für einen direkten Betrieb von leistungsverbrauchenden Bauelementen, wie beispielsweise Halbleiterbauelementen, zu klein. Eine Spannungserhöhung kann auf dreifache Weise dadurch erreicht werden, daß die für die Leistungsversorgung vorgesehene Lichtleistung mehreren in Serie geschalteten Fotoelementen OEW zugefürt wird und/oder daß dem oder den Fotoelementen OEW ein Spannungswandler SW, beispielsweise ein Gleichspannungswandler, vorzugsweise in Verbindung mit einem Speicher SF für elektrische Energie nachgeschaltet ist.

Der Spannungswandler SW und der Speicher SF können dem elektrischen Teil der Sensoreinrichtung SE zugerechnet werden. Vorzugsweise weist die Sensoreinrichtung SE außerdem ein Sensorelement S auf, das eine von den abgetasteten Meßwerten abhängige Spannung U erzeugt, sowie eine elektronische Einrichtung EE, welche die von dem Sensorelement S erzeugte Spannung U in eine von dieser abhängigen, zur Ansteuerung des elektrooptischen Modulators EOM geeigneten Spannung $U_m = f(U)$ umwandelt. Diese Spannung $U_m$ kann eine Wechselspannung sein, deren Frequenz durch die von dem Sensorelement S erzeugte Spannung U gesteuert oder moduliert wird (Frequenzmodulation). Sie kann aber auch eine Impulsfolge sein, bei der die Impulsphase oder die Impulslänge durch die Spannung U moduliert wird. Die elektronische Einrichtung EE kann aber auch ein binär kodiertes Signal erzeugen, welches die Spannung U aus dem Sensorelement S darstellt.

Vorzugsweise ist eine nahe bei der Sensoreinrichtung SE angeordnete und an das Fotoelement OEW angekoppelte elektrisch steuerbare Unterbrechungseinrichtung UE vorgesehen, mit der die Leistungsversorgung der Sensoreinrichtung SE durch Steuersignale wahlweise unterbrechbar oder einstellbar ist, die über den Lichtwellenleiter LW4 der zweiten optischen Leitung LW3, LW4 zugeführt werden. Die Unterbrechungseinrichtung UE kann beispielsweise aus einer bistabilen Kippschaltung gebildet sein und sie kann gegebenenfalls in den Spannungswandler SW eingebaut sein.

Dadurch kann mit Hilfe einer entsprechenden Vorrichtung während einer Zeitspanne, in der die Leistungs- oder Stromversorgung für die Sensoreinrichtung SE unterbrochen ist, der Speicher SP mit elektrischer Energie, die optische übertragen wurde, aufgeladen werden.

Die Ausgangsspannung $U_m$ aus der elektronischen Einrichtung EE wird dem elektrooptischen Modulator OEM zugeführt, der den Lichtdurchgang entsprechend der Spannung $U_m$ steuert. Der Modulator OEM ist elektrisch gesehen eine kleine Kapazität, er kann ein bekannter Multimodemodulator (siehe Nelson, A. R., McMahon, D.H: Modulators for multimode single fiber communications systems, Proc. of the Technical Program, Electro-Optical Systems Design Conf., New York, 14. - 16. Sept. 1976, S. 36-39), ein Bragg-Modulator (siehe Auracher F., Keil R., Zeitler X.-H: New electrooptic Bragg deflectors with lowinsertion loss and multiplebeam capability, SFEB 10 (1981), Nr, 1, S. 44-47) oder ein Monomodewellenleitermodulator sein (siehe die an den Schluß der Beschreibung angehängte Liste von Literaturstellen).

Der Speicher SP für die elektrische Energie ist vorzugsweise ein wiederaufladbarer Speicher und kann ein Akkumulator, beispielsweise eine NC-Zelle, oder auch einfach ein Kondensator sein.

Die elektronische Einrichtung oder der elektronische Teil der Sensoreinrichtung SE bestehen vorzugsweise aus einer verlustarmen, integrierten CMOS- oder $I^2L$-Halbleiter-schaltung zur Realisierung eines der oben beschriebenen Modulationsverfahren. Solche Schaltungen sind aus der Halbleitertechnologie bekannt und können ohne Schwierigkeiten aufgebaut werden. Spannungswandler sind beispielsweise in Robertson, M.M: Power transfer via fiber optics. Proceedings of the 30th Electronic Components Conference, San Francisco, CA, USA, 28. - 30. April 1980, S. 216-21, und Brosio, A.; Perino, M; Solina, P: A low consumption, light powered telephone on optical fibre, Sixth Europian Conference on Optical Communication, York U.K., 16. - 19. Sept. 1980, S. 242 - 245, erwähnt.

Zur Einkoppelung von Lichtleistung an den entfernten Stellen ST, ST1,ST2 ist vorzugsweise jeweils eine Einrichtung EOL,EOL1, EOL2 zur elektrooptischen Leistungsumwandlung vorgesehen, deren abgebeben Lichtleistung als Signallichtleistung in die weitere optische Leitung LW1 bzw. als Lichtleistung für die Leistungsversorgung in den oder die Lichtwellenleiter LW4 der zweiten optischen Leitung LW3, LW4 eingekoppelt wird. Jede dieser Einrichtungen EOL, EOL1, EOL2 weist einen Eingang e, e1, e2- auf, über die jeweils die in Lichtleistung umzuwandelnde elektrische Leistung zugeführt wird.

Das Licht für die Signallichtleistung und für die Lichtleistung für die elektrische Versorgung kann als Gleichlicht oder moduliert, beispielsweise in Form einer regelmäßigen Impulsfolge, in die entsprechenden optischen Leitungen LW1 bzw. LW3, LW4 eingekoppelt werden. Bei impulsförmiger Einspeisung läßt sich zum einen die Streckenlänge zwischen der Meßstelle bzw. der Sensoreinrichtung und den entfernten Stellen ST,ST1, ST2, beispielsweise in einer Zentrale, infolge jetzt möglicher, hoher Impulsleistungsspitzen verlängern. Zum anderen entstehen durch den vom Fotoelement abgegebenen Wechselstrom Vorteile für die halbleitertechnologische Realisierung des Spannungswandlers SW.

Die Einrichtungen EOL, EOL1, EOL2 zur elektrooptischen Leistungsumwandung können Lichtsender der verschiedensten Art sein: Laser jeder Art, darunter Halbleiterlaser, Festkörperlaser, Gaslaser sowie Lumineszenzdioden. Zur Herstellung von Halbleiterlasern (siehe Panish, M.B: Heterojunction Injection Lasers. IEEE MTT-23 (1975), S. 20 - 30) und Lumineszenzdioden (siehe Lebailly, J: Situation des diodes électroluminescentes pour liaisons par fibres optiques. Acta Electronica 22 (1979), Nr. 4, 8. 301 - 310) werden je nach Lichtwellenlänge verschiedene Materialien benutzt: beispielsweise ternäre Halbleiter wie (GaAl)As oder (InGa)As bzw. quaternäre Halbleiter wie (Galn) (AsP) (siehe Heinlein, W.; Witte, K.H:. Digitale Übertragung über optische Wellenleiter im Wellenlängenbereich oberhalb 1 µm. Frequenz 32 (1978), No. 3, 8. 79 - 84). Für Lumineszenzdioden kommen auch binäre Halbleiter wie GaP in Frage. Gaslaser sind z. B. He-Ne-Laser. Für die zur Leistungsübertragung dienende Einrichtung EOL2 sind auch Xenon-Bogenlampen vesendbar.

An der Entnahmestelle ES, die beispielsweise ebenfalls in der Zentrale liegen kann, ist zweckmäßigerweise ein weiterer optoelektronischer Wandler OEW1 in Form einer Fotodiode oder Avalanchefotodiode mit vorzugsweise nachgeschalteter Verstärkung vorgesehen, welcher das zur Entnahme stelle ES gefuhrte modulierte Signallicht wieder in elektrische Signale umwandelt. Die Fotodioden bestehen meist aus Silizium (siehe Melchior H: Sensitive high speed Photodetectors for the demodulation of visible and near infrared light. J. Luminescence 7 (1973), S. 390 - 414), aber auch Germaniumfotodioden (siehe Anido, H.; Kanbe, H.; Kimura, T.; Yamaoka, T.; Kaneda T: Caracteristics of Germanium Avalanche Fhotodiodes in the Wavelength Region of 1-1.6 µm. IEEE QE-14 (1978), No. 11, S. 804 - 909) für größere Wellenlängen des Lichts kommen in Frage. Wie die Laser- und Lumineszenzdioden können die Fotodioden auch aus ternären oder quarternären Halbleitern hergestellt werden.

Das Fotoelement OEW ist eine spezielle Fotodiode zur Umwandung optischer in elektrische Energie, es wird je nach der Wellenlänge des empfangenen Lichts aus den gleichen Materialien wie die Fotodiode hergestellt.

Die Lichtwellenleiter können Stufenprofil-, Gradienten- oder Monomodewellenleiter sein. Dickkernasern mit besonders großem Kernquerschnitt kommen gleichfalls in Frage.

Die Leistungs- oder Stromversorgung für das Sensorelement ist fakultativ. Es gibt Sensorelemente, die der Meßgröße soviel Leistung entnehmen, daß damit eine Spannung erzeugt werden kann, die zur Ansteuerung der elektronischen Einrichtung EE ausreicht. Derartige Sensoren sind z. B. piezoelektrische Wandler, Thermoelemente, Halleffektwandler usw.

Andere Sensorelemente benötigen zur Erzeugung der Spannung U eine Stromversorgung. Zu diesen gehören z. B. Dehnungsmeßstreifen, beispielsweise in Fom von Brückenschaltungen, kapazitive Druckaufnehmer usw.

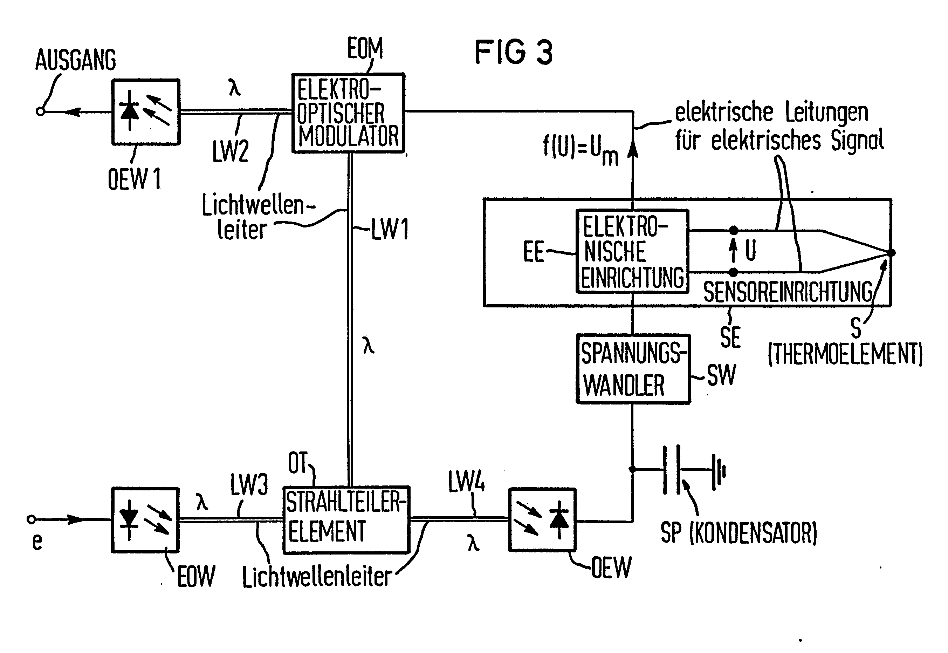

In dem in der Figur 3 dargestellten Ausführungsbeispiel besteht das Sensorelement S der Sensoreinrichtung SE aus einem Thermoelement. Eine Leistungszufuhr zum Sensorelement S ist in diesem Falle nicht notwendig. Der Speicher SF für die elektronische Energie ist durch einen Kondensator verwirklicht.

Bei der in Figur 2 dargestellten Ausführungsform ermöglicht der Multiplexer die Übertragung von Licht unterschiedlicher Wellenlängen für Signallichtleistung und zur Versorgung vorgesehener Lichtleistung auf einem gemeinsamen Lichtwellenleiter.

Eine Vielfachanordnung einer Reihe von Multiplexern zur Vereinigung von Licht mehrerer Lichtwellenlängen auf einer Leitung ist möglich.

Die leistungsverbrauchende Sensoreinrichtung SE, gegebenenfalls mit der elektronischen Einrichtung EE, und die mit diesen elektrisch gekoppelten Teile, also der optoelektronische Wandler OEW, der Spannungswandler SW, gegebenenfalls die Unterbrechungseinrichtung UE, gegebenenfalls der Speicher SP für elektrische Energie und der elektrooptische Modulator EOM werden zweckmäßigerweise zu einer Baueinheit zusammengefaßt. Insbesondere ist es zweckmäßig, die genarnten Teile vollständig so in elektrisch isolierendes Material, beispielsweise FVC, einzubetten oder -gießen, daß nur noch das die Meßwerte abtastende Sensorelement von außen zugänglich ist. Diese Bauweise empfiehlt sich für den Einsatz in Gebieten, in denen Explosionsgefahr und/oder hohe elektrische Potentialdifferenzen herrschen. Es läßt sich mit ihr auf relativ billige Weise ein sehr hoher Sicherheitsgrad erreichen.

Generell ist eine vorgeschlagene Anordnung zur Potentialtrennung hervorragend geeignet.

Der durch optisch zugeführte Energie aufladbare Speicher SP ermöglicht die Überbrückung sehr großer Entfernungen.

Die oben verwendeten Begriffe "entfernt" und "nahe", sind qualitativ zu verstehen. Eine von der Sensoreinrichtung SE entfernte Stelle ist von dieser weiter entfernt als eine nahe bei der Sensoreinrichtung SE befindliche Stelle. In der Praxis wird eine von der Sensoreinrichtung SE entfernte oder weit entfernte Stelle häufig in der Größenordnung von 1 m und mehr von der Sensoreinrichtung entfernt sein, während ein nahe bei der Sensoreinrichtung liegendes Teil in der Größenordnung von 1 cm und darunter, im Fall einer integrierten Schaltung sogar weit darunter, vom Sensorelement entfernt sein wird.

Im folgenden wird eine Zusammenstellung von Monomodelichtwellenleiter-Modulatoren betreffende Literaturstellen angegeben.
/1/ Baues, P.:
Integriert optische Richtkoppler.
Elektronik-Anzeiger 9 (1977), Nr. 3, S. 19-22
/2/ Somekh S.;Carmire, E.; Yarif, A.; Garvin, H.L.; Hunsperger, R.G:
Channel optical waveguide directional couplers.
- Appl. Phys. Lett. 22 (1973), S. 46-47
/3/ Papuchon, M.; Combemale, Y.; Mathieu, X.; Ostrowsky, D.B.; Reiber, L.; Roy, A.M.; Sejourne, B.; Werner, W:
Electrically switched optical directional coupler: Cobra.
Appl. Phys.; Lett 27 (1975), S. 289-291

## Patentansprüche

1. Anordnung zur Übertragung von Meßwerten einer Meßgröße von einer Meßstelle zu einer entfernten Stelle (ES), wobei eine an der Meßstelle angeordnete, die Meßgröße abtastende und die abgetasteten Meßwerte in Form eines meßwertabhängigen Ausgangssignals ($U_m$) ausgebende Sensoreinrichtung (SE) vorgesehen ist, deren elektrisches Ausgangssignal ($U_m$) einem nahe bei der Sensoreinrichtung (SE) angeordneten elektrooptischen Wandler (EOM) zuführbar ist, von dem die optische Signalleistung über eine optische Leitung (LW2) der entfernten Stelle (ES) zuführbar ist, wobei von einer von der Sensoreinrichtung (SE) entfernten Stelle (ST, STI, ST2) über eine zweite optische Leitung (LW3, LW4) eine für eine Leistungsversorgung der Sensoreinrichtung (SE) vorgesehene optische Leistung wenigstens einem nahe bei der Sensoreinrichtung (SE) angeordneten und mit dieser sowie mit einem Speicher (SP) für elektrische Energie in Verbindung stehenden optoelektronischen Wandler (OEW) zuführbar ist, der die zugeführte optische Leistung in eine elektrische Leistung umwandelt, die für den Betrieb einer elektronischen Einrichtung (EE) der Sensoreinrichtung (SE) erforderlich ist, welche elektronische Einrichtung (EE) mit einem Sensorelement (S) dieser Sensoreinrichtung (SE) verbunden ist, das ein von den abgetasteten Meßwerten abhängiges elektrisches Signal (U) erzeugt, welches von der elektronischen Einrichtung (EE) in ein von diesem Signal (U) abhängiges, zur Ansteuerung des elektrooptischen Wandlers (EOM) geeignetes elektrisches Signal ($U_m$) umgewandelt wird, dadurch gekennzeichnet, daß der elektrooptische Wandler (EOM) als elektrooptischer Modulator ausgebildet ist, daß in der zweiten optischen Leitung (LW3, LW4) eine optische Teilereinrichtung (OT) angeordnet ist, welche von der zugeführten optischen Leistung einen Anteil abzweigt, der über eine weitere optische Leitung (LW1) dem elektrooptischen Modulator (EOM) als eine optische Signalleistung zuführbar ist, der in dem Modulator (EOM) das elektrische Ausgangssignal ($U_m$) aufprägbar ist und von dem die entsprechend modulierte optische Signalleistung über die eine optische Leitung (LW2) der entfernten Stelle (ES) zuführbar ist, daß dem optoelektronischen Wandler (OEW) ein Spannungswandler (SW) nachgeschaltet ist, der mit dem Speicher (SP) und der Sensoreinrichtung (SE) verbunden ist, und daß zumindest die elektronische Einrichtung (EE) und der Spannungswandler (SW) aus einer verlustarmen integrierten CMOS- oder $I^2L$-Halbleiterschaltung gebildet sind.

2. Anordnung nach Anspruch 1, dadurch gekennzeichnet, daß mehrere in Serie geschaltete optoelektronische Wandler (OEW) vorgesehen sind, denen der Spannungswandler (SW) nachgeschaltet ist.

3. Anordnung nach Anspruch 1 oder 2, dadurch gekennzeichnet, daß der Speicher (SP) für elektrische Energie in einer CMOS- oder $I^2L$-Halbleiterschaltung realisiert ist.

4. Anordnung nach einem der vorhergehenden Ansprüche, dadurch gekennzeichnet, daß das von der elektronischen Einrichtung (EE) erzeugte elektrische Signal ($U_m$) eine Wechselspannung, deren Frequenz durch das von dem Sensorelement (S) erzeugte elektrische Signal (U) moduliert wird, oder eine Impulsfolge bei der die Impulsphase und/oder die Impulslänge durch das elektrische Signal (U) aus dem Sensorelement (S) moduliert wird, oder ein das elektrische Signal (U) aus dem Sensorelement (S) darstellendes binär kodiertes Signal ist.

5. Anordnung nach einem der vorhergehenden Ansprüche, dadurch gekennzeichnet, daß eine nahe bei der Sensoreinrichtung (SE) angeordnete, an den optoelektronischen Wandler (OEW) angekoppelte elektrisch steuerbare Unterbrechungseinrichtung (UE) vorgesehen ist, mit der die Leistungsversorgung der Sensoreinrichtung (SE) durch über die zweite optische Leitung (LW3, LW4) zugeführte Steuersignale wahlweise unterbrechbar oder einschaltbar ist.

6. Anordnung nach Anspruch 5, dadurch gekennzeichnet, daß die Unterbrechungseinrichtung (UE) aus einer bistabilen Kippschaltung gebildet ist.

7. Anordnung nach Anspruch 5 oder 6, dadurch gekennzeichnet, daß eine Ladevorrichtung vorgesehen ist, welche während einer Zeitspanne, in der die Leistungsversorgung für die Sensoreinrichtung (SE) unterbrochen ist, den Speicher (SP) für die elektrische Energie aus optisch übertragener Energie auflädt.

8. Anordnung nach einem der vorhergehenden Ansprüche, dadurch gekennzeichnet, daß zumindest eine der optischen Leitungen (LW1; LW2; LW3, LW4) aus einer Dickkernfaser, im Falle der zweiten optischen Leitung (LW3, LW4) auch aus mehreren Dickkernfasern besteht.

9. Anordnung nach einem der vorhergehenden Ansprüche, dadurch gekennzeichnet, daß der elektrooptische Modulator (EOM) aus einem Monomodewellenleitermodulator oder einem Multimodemodulator besteht.

10. Anordnung nach Anspruch 9, dadurch gekennzeichnet, daß der Multimodemodulator ein Bragg-Modulator ist.

11. Anordnung nach einem der vorhergehenden Ansprüche, dadurch gekennzeichnet, daß die optische Teilereinrichtung (OT) aus einem Strahlteilerelement besteht, das aus der über die zweite optische Leitung (LW3, LW4) übertragenen optischen Leistung einer bestimmten Wellenlänge einen bestimmten Anteil auskoppelt.

12. Anordnung nach einem der Ansprüche 1 bis 10, dadurch gekennzeichnet, daß die optische Teilereinrichtung (OT) aus einem Wellenlängendemultiplexer besteht, der aus der von der zweiten optischen Leitung (LW3, LW4) übertragenen optischen Leistung, in der zwei Wellenlängen ($\lambda_1, \lambda_2$) enthalten sind, eine Wellenlänge ($\lambda_1$) auskoppelt, die über die weitere optische Leitung (LWI) dem elektrooptischen Modulator (EOM) zugeführt ist.

13. Anordnung nach Anspruch 12, dadurch gekennzeichnet, daß ein Wellenlängenmultiplexer (WM) vorgesehen ist, dem von einer von der Sensoreinrichtung (SE) entfernten zweiten Stelle (ST1) eine optische Leistung der einen Wellenlänge ($\lambda_1$) und von einer von der Sensoreinrichtung (SE) entfernten dritten Stelle (ST2) eine optische Leistung der anderen Wellenlänge ($\lambda_2$) zugeführt sind und von dem die optischen Leistungen gemeinsam in die zweite optische Leitung (LW3) eingekoppelt sind.

14. Anordnung nach Anspruch 12 oder 13, dadurch gekennzeichnet, daß die in die zweite optische Leitung (LW3) eingekoppelte optische Leitung der einen Wellenlänge ($\lambda_1$) kleiner ist als die ebenfalls in diese Leitung (LW3) eingekoppelte optische Leistung der anderen Wellenlänge ($\lambda_2$).

15. Anordnung nach einem der vorhergehenden Ansprüche, dadurch gekennzeichnet, daß die optische Teilereinrichtung (OT) die über die zweite optische Leitung (LW3, LW4) zugeführte optische Leistung in zwei ungleiche Leistungsanteile aufteilt und daß der kleinere Leistungsanteil in die weitere optische Leitung (LWI) eingekoppelt ist.

16. Anordnung nach Anspruch 15, dadurch gekennzeichnet, daß der kleinere Leistungsanteil etwa ein Zehntel des anderen Leistungsanteils beträgt.

17. Anordnung nach einem der vorhergehenden Ansprüche, dadurch gekennzeichnet, daß für jede Wellenlänge ($\lambda$, $\lambda_1$, $\lambda_2$) eine Einrichtung (EOL, EOLI, EOL2) zur elektrooptischen Leistungsumwandlung vorgesehen ist, deren optische Ausgangsleistung in die zweite optische Leitung (LW3, LW4) einkoppelbar ist und/oder daß ein weiterer optoelektronischener Wandler (OEWI) vorgesehen ist, in dem die zur Entnahmestelle (ES) geführte modulierte optische Signalleistung einkoppelbar ist.

18. Anordnung nach Anspruch 17, dadurch gekennzeichnet, daß eine Einrichtung (EOL, EOLI, EOL2) zur elektrooptischen Leistungsumwandlung einen Lichtsender in Form eines Lasers, einer Lumineszenzdiode oder einer Xenon-Bogenlampe aufweist.

19. Anordnung nach Anspruch 17 oder 18, dadurch gekennzeichnet, daß eine Einrichtung (EOL, EOLI; EOL2) zur elektrooptischen Leistungsumwandlung Gleichlicht oder eine regelmäßige Impulsfolge als optische Ausgangsleistung abgibt.

20. Anordnung nach einem der Ansprüche 17 bis 19, dadurch gekennzeichnet, daß der weitere optoelektronische Wandler (OEWI) eine Fotodiode oder Avalanche-Fotodiode mit nachgeschalteter Verstärkung aufweist.

**Claims**

1. An arrangement for transmitting measured values of a quantity to be measured from a measuring station to a remote station (ES), where a sensor device (SE) is provided which is arranged at the measuring station, samples the quantity to be measured and emits the sampled measured values in the form of a measured-value-dependent electrical output signal ($U_m$), and whose electrical output signal ($U_m$) can be supplied to an electro-optical transducer (EOM) which is arranged in the vicinity of the sensor device (SE) and from which the optical signal power can be fed via an optical line (LW2) to the remote station (ES), where optical power which is provided for the power supply of the sensor device (SE) can be supplied from a station (ST,ST1,ST2) remote from the sensor device (SE) via a second optical line to at least one opto-electronic transducer (OEW) which is arranged in the vicinity of the sensor device (SE) and is connected to the latter and to a store (SP) for electrical energy and which convert the supplied optical power into electrical power which is required for the operation of an electronic device (EE) of the sensor device (SE), where the electronic device (EE) is connected to a sensor element (S) of the sensor device (SE) that produces an electrical signal (U) which is dependent upon the sampled measured values and which is converted by the electronic device (EE) into an electrical signal ($U_m$) which is dependent upon the signal (U) and which is suitable to operate the electro-optical transducer (EOM), characterised in that the electro-optical transducer (EOM) is designed as an electro-optical modulator, that the second optical line (LW3, LW4) includes an optical divider device (OT) which branches off a component of the supplied optical power which can be supplied via a further optical line (LW1) to the electro-optical modulator (EOM) as optical signal power onto which the electrical output signal ($U_m$) can be impressed in the modulator (EOM) and from which the appropriately modulated, optical signal power can be fed via the first optical line (LW2) to the remote station (ES), that the opto-electronic transducer (OEW) is connected at its output end to a voltage converter (SW) which is connected to the store (SP) and to the sensor device (SE), and that at least the electronic device (EE) and the voltage converter (SW) comprises a low-loss, integrated CMOS or I2L-semiconductor circuit.

2. An arrangement as claimed in claim 1, characterised in that a plurality of series-connected, opto-electronic transducers (OEW) are provided which are connected at their output end to the voltage converter (SW).

3. An arrangement as claimed in claim 1 or 2, characterised in that the store (SP) for electrical energy is constructed in a CMOS or I2L-semiconductor circuit.

4. An arrangement as claimed in one of the preceding claims, characterised in that the electrical signal ($U_m$) produced by the electronic device (EE) is an alternating voltage, whose frequency is modulated by the electrical signal (U) produced by the sensor element (S), or a pulse sequence in which the pulse phase and/or the pulse length is modulated by the electrical signal (U) from the sensor element (S), or a binary coded signal which represents the electrical signal (U) from the sensor element (S).

5. An arrangement as claimed in one of the preceding claims, characterised in that an electrically controllable interruption device (UE) is provided which is arranged in the vicinity of the sensor device (SE), is coupled to the opto-electronic transducer (OEW) and by which the power supply of the sensor device (SE) can be optionally interrupted or connected by control signals which are supplied via the second optical line (LW3,LW4).

6. An arrangement as claimed in claim 5, characterised in that the interruption device (UE) comprises a bistable circuit.

7. An arrangement as claimed in claim 5 or 6, characterised in that a charging device is provided which, during a period of time in which the power supply to the sensor device (SE) is interrupted, charges the store (SP) for electrical energy from optically transferred energy.

8. An arrangement as claimed in one of the preceding claims, <u>characterised in</u> that at least one of the optical lines (LWI; LW2; LW3, LW4) comprises a thick-core fibre, and in the case of the second optical line (LW3, LW4) comprises a plurality of thick-core fibres.

9. An arrangement as claimed in one of the preceding claims, <u>characterised in</u> that electro-optical modulator (EOM) comprises a monomode-waveguide modulator or a multimode modulator.

10. An arrangement as claimed in claim 9, <u>characterised in</u> that the multimode modulator is a Bragg modulator.

11. An arrangement as claimed in one of the preceding claims, <u>characterised in</u> that the optical divider device (OT) comprises a beam divider element which output-couples a specific component of the optical power of a specific wavelength which is transmitted via the second optical line (LW3, LW4).

12. An arrangement as claimed in one of the claims 1 to 10, <u>characterised in</u> that the optical divider device (OT) comprises a wavelength demultiplexer which, from the optical power which is transmitted by the second optical line (LW3, LW4) and which includes two wavelengths $(\lambda_1, \lambda_2)$, output-couples a wavelength $(\lambda_1)$ which is fed via the further optical line (LW1) to the electro-optical modulator (EOM).

13. An arrangement as claimed in claim 12, <u>characterised in</u> that a wavelength multiplexer (WM) is provided which is supplied from a second station (ST1), remote from the sensor device (SE) with optical power of the first wavelength $(\lambda_1)$ and is supplied from a third station (ST2), remote from the sensor device (SE), with optical power of the other wavelength $(\lambda_2)$, and by which the optical powers are commonly input-coupled into the second optical line (LW3).

14. An arrangement as claimed in claim 12 or 13, <u>characterised in</u> that the optical power of the first wavelength $(\lambda_1)$ which is input-coupled into the second optical line (LW3) is smaller than the optical power of the other wavelength $(\lambda_2)$ which is likewise input-coupled into this line (LW3).

15. An arrangement as claimed in one of the preceding claims, <u>characterised in</u> that the optical divider device (OT) divides into two unequal components the optical power which is supplied via the second optical line (LW3, LW4), and that the smaller power component is input-coupled into the further optical line (LW1).

16. An arrangement as claimed in claim 15, <u>characterised in</u> that the smaller power component amounts to approximately one tenth of the other power component.

17. An arrangement as claimed in one of the preceding claims, <u>characterised in</u> that for each wavelength $(\lambda, \lambda_1, \lambda_2)$ a device (EOL, EOL1, EOL2) is provided for electro-optical power conversion, the optical output power of which can be input-coupled into the second optical line (LW3, LW4) and/or that a further opto-electronic transducer (OEW1) is provided into which the modulated, optical signal power supplied to the removing station (ES), can be input-coupled.

18. An arrangement as claimed in claim 17, <u>characterised in</u> that a device (EOL, EOL1, EOL2) for electro-optical power conversion includes a light transmitter in the form of a laser, a light-emitting diode or a xenon-arc lamp.

19. An arrangement as claimed in claim 17 or 18, <u>characterised in</u> that a device (EOL, EOL1, EOL2) for electro-optical power conversion emits constant light or a regular pulse sequence as optical output power.

20. An arrangement as claimed in one of the claims 17 to 19, <u>characterised in</u> that the further opto-electronic transducer (OEW1) includes a photo-diode or avalanche photo-diode followed by an amplifier.

## Revendications

1. Dispositif pour transmettre des valeurs mesurées d'une grandeur de mesure depuis un point de mesure jusqu'à un emplacement éloigné (ES), et dans lequel il est prévu un dispositif de détection (SE) disposé au niveau du point de mesure et envoyant les valeurs mesurées explorées sous la forme d'un signal de sortie $(U_m)$ dépendant de la valeur mesurée, et dont le signal de sortie électrique $(U_m)$ peut être envoyé à un convertisseur électro-optique (EOM) disposé à proximité du dispositif de détection (SE) et par lequel la puissance optique du signal peut être envoyée par l'intermédiaire d'une ligne optique (LW2) à l'emplacement éloigné (ES), et dans lequel une puissance optique prévue pour une alimentation en puissance du dispositif de détection (SE) peut être envoyée depuis un emplacement (ST, ST1, ST2) éloigné du dispositif de détection (SE), par l'intermédiaire d'une seconde ligne optique (LW3, LW4), à au moins un convertisseur électro-optique (OEW) disposé à proximité du dispositif de détection (SE) et relié à ce dernier ainsi qu'un dispositif de stockage (SP) pour l'énergie électrique, et qui convertit la puissance optique envoyant une puissance électrique qui est nécessaire pour le fonctionnement d'un dispositif électronique (EE) du dispositif de détection (SE), lequel dispositif électronique (EE) est relié à un élément formant capteur (S) de ce dispositif de détection (SE), qui produit un signal électrique (U) dépendant des valeurs mesurées explorées et qui est converti par le dispositif électronique (EE) en un signal électrique $(U_m)$ dépendant de ce signal (U) et convenant pour la commande du convertisseur électronique (EOM), caractérisé par le fait que le convertisseur électro-optique (EOM) est réalisé sous la forme d'un modulateur électro-optique, que dans la seconde ligne optique (LW3, LW4) se trouve disposé un dispositif diviseur optique (OT) qui dérive une partie de la puissance optique envoyée, qui peut être envoyée par l'intermédiaire d'une autre ligne optique (LW1) au modulateur électrooptique (OEM) sous la forme d'une puissance de signal optique, à laquelle peut être ajouté le signal de sortie électrique $(U_m)$, dans le modulateur (EOM), et dont la puissance optique du signal modulée de façon correspondante peut être envoyée par l'intermédiaire d'une ligne optique (LW2) à l'emplacement éloigné (ES), qu'en aval du convertisseur optoélectronicue (EOW) se trouve branché un transformateur de tension (LW) qui est relié au dispositif de stockage (Sp) et au dispositif de détection (SE) et qu'au moins le dispositif électronique (EE) et le convertisseur de tension (SW) sont constitués par un circuit à semiconducteurs CMOS ou I²L intégré, présentant de faibles pertes.

2. Dispositif suivant la revendication 1, caractérisé par le fait qu'il est prévu plusieurs convertisseurs optoélectroniques (OEW) branchés en série et en aval desquels est branché le convertisseur de tension (SW).

3. Dispositif suivant la revendication 1 ou 2, caractérisé par le fait que le dispositif de stockage (SP) pour l'énergie électrique est réalisé au moyen d'un circuit à semiconducteurs CMOS ou I²L.

4. Dispositif suivant l'une des revendications précédentes, caractérisé par le fait que le signal électrique $(U_m)$ produit par le dispositif électronique (EE) est une tension alternative, dont la fréquence est modulée par le signal électrique (U) produit par l'élément formant capteur (S), ou un train d'impulsions, dans lequel la phase et/ou la durée des impulsions est modulée par le signal électrique (U) délivré par l'élément formant capteur (S), ou bien un signal codé en binaire représentant le signal électrique (U) délivré par l'élément formant capteur (S).

5. Dispositif suivant l'une des revendications précédentes, caractérisé par le fait qu'il est prévu un dispositif interrupteur (UE) pouvant être commandé électriquement, disposé à proximité du dispositif de détection (SE) et accouplé au convertisseur optoélectronique (OEW) et à l'aide duquel l'alimentation en énergie du dispositif de détection (SE) peut être au choix interrompue ou branchée par des signaux de commande envoyés par l'intermédiaire de la seconde ligne optique (LW3, LW4).

6. Dispositif suivant la revendication 5, caractérisé par le fait que le dispositif d'interruption (UE) est formé par un circuit à bascule bistable.

7. Dispositif suivant la revendication 5 ou 6, caractérisé par le fait qu'il est prévu un dispositif de charge qui, pendant un intervalle de temps pendant lequel l'alimentation en énergie du dispositif de détection (SE) est interrompue, charge le dispositif de stockage (Sp) pour l'énergie électrique, à partir d'une énergie transmise optiquement.

8. Dispositif suivant l'une des revendications précédentes, caractérisé par le fait qu'au moins l'une des lignes optiques (LW1; LW2; LW3; LW4) est constitué par une fibre à coeur épais, et que dans le cas de la seconde ligne optique (LW3, LW4) il est également prévu plusieurs fibres à coeur épais.

9. Dispositif suivant l'une des revendications précédentes, caractérisé par le fait que le modulateur électrooptioue (EOM) est constitué par un modulateur à guides d'ondes monomode ou par un modulateur multimode.

10. Dispositif suivant la revendication 9, caractérisé par le fait que le modulateur multimode est un modulateur de Bragg.

11. Dispositif suivant l'une des revendications précédentes, caractérisé par le fait que le dispositif diviseur optique (OT) est constitué par un élément diviseur de rayonnement, qui extrait. par découplage une partie déterminée de la puissance optique transmise par l'intermédiaire de la seconde ligne optique (LW3, LW4) et possédant une longueur d'onde déterminée.

12. Dispositif suivant l'une des revendications 1 à 10, caractérisé par le fait que le dispositif diviseur optique (OT) est constitué par des multiplexeurs de longueurs d'onde, qui extraient par découplage, à partir de la puissance optique transmise par la seconde ligne optique (LW3, LW4), qui contient deux longueurs d'onde $(\lambda_1, \lambda_2)$, une longueur d'onde $(\lambda_1)$ qui est envoyée par l'intermédiaire de l'autre ligne optique (LW1) au modulateur électro-optique (EOM).

13. Dispositif suivant la revendication 12, caractérisé par le fait qu'il est prévu un multiplexeur de longueurs d'ondes (LWM), auquel une puissance optique possédant une longueur d'onde $(\lambda_1)$ est envoyée à partir d'un second emplacement (ST1) éloigné du dispositif de détection (SE), et une puissance optique possédant l'autre longueur d'onde $(\lambda_2)$ est envoyé à partir d'un troisième emplacement (ST2) éloigné dudispositif de détection (SE) et par lequel les puissances optiques sont injectées en commun par couplage dans la seconde ligne optique (SW3).

14. Dispositif suivant la revendication 12 ou 13, caractérisé par le fait que la puissance optique injectée par couplage dans la seconde ligne optique (LW3) et possédant une longueur d'onde $(\lambda_1)$ est inférieure à la puissance optique injectée également par couplage dans cette ligne (LW3) et possédant l'autre longueur d'onde $(\lambda_2)$.

15. Dispositif suivant l'une des revendications précédentes, caractérisé par le fait que le dispositif diviseur optique (OT) subdivise la puissance optique envoyée par l'intermédiaire de la seconde ligne optique (LW3, LW4) en deux composantes non identiques de puissance et que la plus faible composante de puissance est injectée par couplage dans l'autre ligne optique (LW1).

16. Dispositif suivant la revendication 15, caractérisé par le fait que la composante la plus faible de la puissance est égale approximativement au dixième de l'autre composante de la puissance.

17. Dispositif suivant l'une des revendications précédentes, caractérisé par le fait que pour chaque longueur d'onde ($\lambda$, $\lambda_1$, $\lambda_2$) il est prévu un dispositif (EOL, EOL1, EOL2) servant à réaliser la conversion de puissance électro-optique, dont la puissance de sortie optique doit être injectée par couplage dans la seconde ligne optique (LW3, LW4), et/ou qu'il est prévu un autre transducteur optoélectronique (OW1), dans lequel la puissance de signal optique modulée, envoyée au point de prélèvement (ES), peut être injectée par couplage.

18. Dispositif suivant la revendication 17, caractérisé par le fait qu'un dispositif (EOL, EOL1, EOL2) servant à réaliser la conversion de puissance électro-optique comporte un émetteur de lumière réalisé sous la forme d'un laser, d'une diode à luminescence ou d'une lampe à arc au xénon.

19. Dispositif suivant la revendication 17 ou 18, caractérisé par le fait qu'un dispositif (EOL, EOL1, EOL2) servant à réaliser la conversion de puissance électro-optique délivre une lumière continue ou une suite régulière d'impulsions comme puissance de sortie optique.

20. Dispositif suivant l'une des revendications 17 à 19, caractérisé par le fait que l'autre transducteur optoélectronique (EOW1) comporte une photodiode ou une photodiode à avalanche muni d'un dispositif amplificateur branché en aval.

FIG 1

**OEW1**

**EOM**

ELEKTRO-
OPTISCHER
MODULATOR

AUSGANG

ES

λ

LW2

Lichtwellenleiter

λ

LW1

elektrische Leitungen
für elektrisches Signal
$f(U)=U_m$

S

ELEKTRO-
NISCHE
EINRICHTUNG

U

SENSOR-
ELEMENT

Meßgröße

SENSOR-
EINRICHTUNG

SP

SPEICHER

SPANNUNGS-
WANDLER

SW

UE

SE

EINGANG

e

EOL

ST

λ

LW3

STRAHLTEILER-
ELEMENT

OT

λ

LW4

OEW

elektrische Leitungen
für Stromversorgung

Lichtwellenleiter

0 075 699

FIG 2

OEW1
ES
AUSGANG
$\lambda_1$
LW2
Lichtwellenleiter

ELEKTRO-
OPTISCHER
MODULATOR
EOM

$U_m = f(U)$

elektrische Leitungen
für elektrisches Signal

$\lambda_1$
LW1

SE
SENSOR-
EINRICHTUNG

EE
ELEKTRO-
NISCHE
EINRICHTUNG

U

SENSOR-
ELEMENT
S

Meßgröße

SP
SPEICHER

SPANNUNGS-
WANDLER
UE
SW

EOL1
ST1
$\lambda_1$
$e_1$
Lichtwellenleiter

LW11

EINGÄNGE

EOL2
$e_2$
$\lambda_2$
ST2

WELLEN-
LÄNGEN-
MULTIPLEXER
$\lambda_1$
$\lambda_2$
WM
LW12

$\lambda_1/\lambda_2$

LW3

WELLEN-
LÄNGEN-
DEMULTI-
PLEXER

Lichtwellenleiter

LW4

$\lambda_2$

OEW

elektrische Leitungen
für Stromversorgung

0 075 699

FIG 3

AUSGANG

OEW 1

LW2

Lichtwellenleiter

λ

EOM

ELEKTRO-
OPTISCHER
MODULATOR

LW1

λ

elektrische Leitungen
für elektrisches Signal

$f(U)=U_m$

EE — ELEKTRO-
NISCHE
EINRICHTUNG

U

SENSOREINRICHTUNG

SE

S

(THERMOELEMENT)

SPANNUNGS-
WANDLER — SW

OT

STRAHLTEILER-
ELEMENT

LW4

λ

OEW

SP (KONDENSATOR)

e

EOW

LW3

λ

Lichtwellenleiter

0 075 699